# EUROPEAN PATENT APPLICATION

(11) **EP 4 583 678 A1**
(43) Date of publication of application: **09.07.2025**
(21) Application number: 24220048.3
(22) Date of filing: 16.12.2024
(51) Int. Cl.: H10K 59/38, H10K 59/80, H10K 50/86

(54) **DISPLAY PANEL**

(30) Priority: 02.01.2024 CN 202410002673
(71) Applicant: InnoLux Corporation, Jhunan Town Miao li 35053 (TW)
(72) Inventor: LIU, Pei-Hsien, 35053 Jhunan Town, Miaoli County (TW); HSIEH, Chi-Han, 35053 Jhunan Town, Miaoli County (TW); KUO, Chiung-Chieh, 35053 Jhunan Town, Miaoli County (TW); KUO, Kuan-Hung, 35053 Jhunan Town, Miaoli County (TW)
(74) Representative: Becker, Eberhard

(57) **Abstract**

A display panel (100) including a first substrate (110), a second substrate (160), a plurality of light emitting units (130), and a color filter layer (150) is provided. The second substrate (160) is disposed opposite to the first substrate (110). The second substrate (160) includes a first surface (161) and a second surface (162). The light emitting units (130) are disposed on the first substrate (110). The color filter layer (150) is disposed between the light emitting units (130) and the second substrate (160). The color filter layer (150) includes a black matrix (BM), a first color resist (151), and a second color resist (152). The black matrix (BM) is disposed on the first color resist (151). One portion of the black matrix (BM) is disposed between the first color resist (151) and the second color resist (152). The display panel (100) provided in the disclosure is capable of reducing the reflectivity of external light or enhancing visual perception.

## Description

### BACKGROUND

### Technical Field

The disclosure relates to a display panel; more particularly, the disclosure relates to a display panel which is capable of reducing reflectivity of external light or enhancing visual perception.

### Description of Related Art

Electronic devices or tiled electronic devices have found widespread application across diverse sectors, encompassing communications, displays, vehicular technology, and aviation. With the robust progress within the industry, the electronic devices are evolving toward increasingly compact and slender designs. Consequently, the imperatives for ensuring the reliability and quality of these electronic devices have escalated.

### SUMMARY

The disclosure provides a display panel capable of reducing reflectivity of external light or enhancing visual perception.

According to an embodiment of the disclosure, a display panel includes a first substrate, a second substrate, a plurality of light emitting units, and a color filter layer. The second substrate is disposed opposite to the first substrate and includes a first surface and a second surface. The light emitting units are disposed on the first substrate. The color filter layer is disposed between the second substrate and the light emitting units and includes a black matrix, a first color resist, and a second color resist, where the black matrix is disposed below the first color resist. One portion of the black matrix is disposed between the first color resist and the second color resist.

According to an embodiment of the disclosure, a display panel includes a first substrate, a second substrate, a plurality of light emitting units, a color filter layer, and an index matching film (IMF). The second substrate is disposed opposite to the first substrate and includes a first surface and a second surface. The light emitting units are disposed on the first substrate. The color filter layer is disposed between the light emitting units and the second substrate and includes a black matrix, a first color resist, and a second color resist, where one portion of the black matrix is disposed between the first color resist and the second color resist. The IMF is disposed between the second substrate and the color filter layer. A refractive index of the IMF ranges from a refractive index of the second substrate to a refractive index of the black matrix.

Several exemplary embodiments accompanied with figures are described in detail below to further describe the disclosure in details.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is a schematic cross-sectional view of a display panel according to a first embodiment of the disclosure.
FIG. 2 is a schematic cross-sectional view of a display panel according to a second embodiment of the disclosure.
FIG. 3 is a schematic cross-sectional view of a display panel according to a third embodiment of the disclosure.
FIG. 4 is a schematic cross-sectional view of a display panel according to a fourth embodiment of the disclosure.
FIG. 5 is a schematic cross-sectional view of a display panel according to a fifth embodiment of the disclosure.
FIG. 6 is a schematic cross-sectional view of a display panel according to a sixth embodiment of the disclosure.

### DETAILED DESCRIPTION OF DISCLOSED EMBODIMENTS

The disclosure may be understood with reference to the following detailed description with the drawings. Note that for clarity of description and ease of understanding, the drawings of the disclosure show a part of an electronic device, and certain components in the drawings may not be drawn to scale. In addition, the number and size of each device shown in the drawings simply serve for exemplifying instead of limiting the scope of the disclosure.

In the following description and claims, terminologies, such as "include," "comprise," and "have", are used in an open-ended manner, and thus should be interpreted as "including, but not limited to".

It should be understood that when an element or a film layer is referred to as being "on" or "connected to" another element or film layer, it can be directly on or connected to the another element or film layer, or an intermediate element or film layer may also be present. By contrast, when an element or a film layer is referred to as being "directly on" or "directly connected to" another element or film layer, no intermediate element or film layer is present.

In addition, relative terminologies, such as "below" or "bottom" and "above" or "top," may be applied in the embodiments to describe a relative relationship of one element to another element in the drawings. It should be understood that if a device in the figures is turned upside down, elements described on a "lower" side becomes elements described on an "upper" side.

In the context of the specification and claims, the utilization of ordinal indicators like "first," "second," "third," and so forth, in relation to modifying elements, does not inherently suggest or signify the presence of any preceding ordinal numbers for said elements. Nor do these indicators imply a sequential relationship between elements, either in terms of their assembly or within the manufacturing process. The primary purpose of these ordinal indicators is to unambiguously differentiate an element bearing a specific name from another element bearing the same name. It should be noted that while the indicators employed in the claims and specification might diverge, the ordinal assignment can also differ; consequently, an element indicated as being the "first" in the specification might correspond to the "second" element as indicated in the claims.

The terminologies "about," "approximately," "substantially," and "roughly" are generally construed as within 0% of a given value or range, or construed as within 5%, 3%, 2%, 1%, or 0.5% of the given value or range. The quantities given here are approximate quantities; namely, even without specifically stating "about," "approximately," "substantially," and "roughly", the meaning of "about," "approximately," "substantially," and "roughly" may still be implied.

In some embodiments of the disclosure, terminologies in association with bonding and connection, such as "being coupled to" and "interconnection", unless otherwise specified, may mean that two structures are in direct contact, or two structures are not in direct contact, where other structures are placed between the two structures. Besides, the terminologies in association with bonding and connection may also refer to the situation that both structures are movable, or both structures are fixed. In addition, the terminology "being coupled to" used herein includes any direct or indirect electrical connection means.

In this disclosure, measurement of length, width, thickness, height, or area, or measurement of distance or interval between elements may be done by applying an optical microscope (OM), a scanning electron microscope (SEM), an alpha step (α-step) profilometer, an ellipsometer, or any other appropriate measurement method. Specifically, according to some embodiments, the SEM may be applied to obtain a cross-sectional image of a to-be-measured element, and the width, the thickness, the height, or the area of each element or the distance or the interval between the elements may be measured, which should not be construed as a limitation in the disclosure.

The display panel provided herein may be applied to an electronic device. Here, the electronic device provided in the disclosure may include but is not limited to a display device, an antenna device, a communication device, a sensing device, or a tiled device. The electronic device may include a bendable or flexible electronic device. The electronic device may include but is not limited to, for instance, liquid crystals (LC), light emitting diodes, quantum dot (QD), fluorescence, phosphor, other suitable materials, or a combination of the above. The antenna device may include but is not limited to a phase array antenna. The tiled device may include but is not limited to, for instance, a display tiled device or an antenna tiled device. It should be noted that the electronic device may be arranged and combined in any manner described above, which should not be construed as a limitation in the disclosure. In the disclosure, a display device in an electronic device is exemplified below for explanation, which should not be construed as a limitation in the disclosure.

Note that in the following embodiments, the technical features provided in several different embodiments may be replaced, reorganized, and mixed without departing from the spirit of the disclosure to complete other embodiments. The technical features of the embodiments may be mixed and matched arbitrarily if they do not violate the spirit of the disclosure or conflict with each other.

Reference will now be made in detail to the exemplary embodiments of the disclosure, and examples of the exemplary embodiments are illustrated in the accompanying drawings. Whenever possible, the same reference numbers are used in the drawings and descriptions to indicate the same or similar parts.

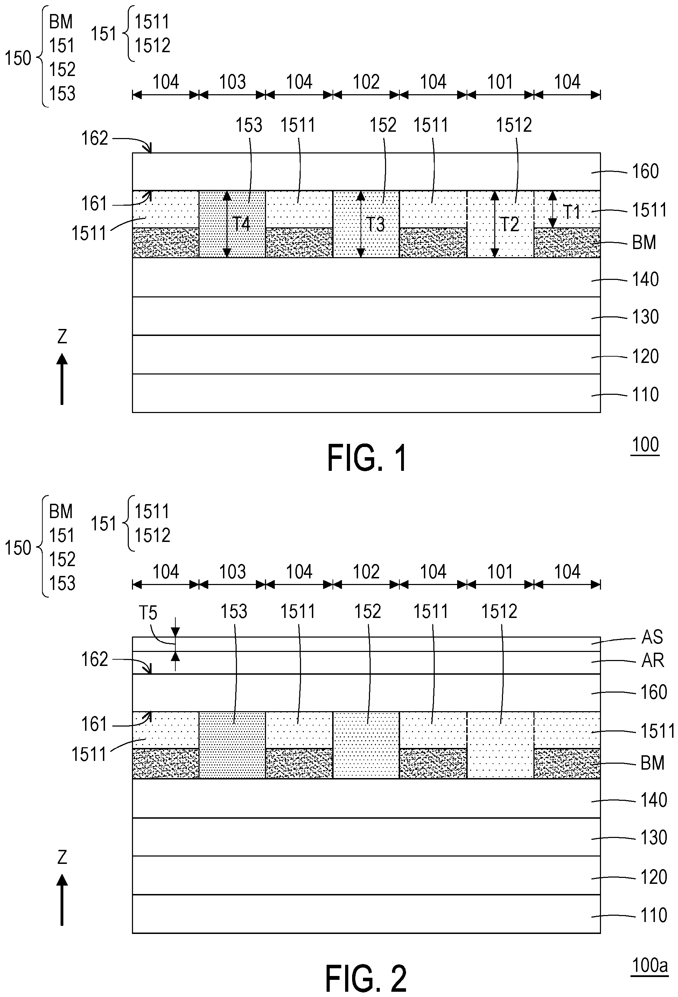

FIG. 1 is a schematic cross-sectional view of a display panel according to a first embodiment of the disclosure. With reference to FIG. 1, a display panel 100 provided in this embodiment includes a first substrate 110, a circuit layer 120, a plurality of light emitting units 130, an intermediate layer 140, a color filter layer 150, and a second substrate 160. In addition, the display panel 100 has a first sub-pixel region 101, a second sub-pixel region 102, a third sub-pixel region 103, and a light shielding region 104, and the sub-pixel regions (i.e., the first sub-pixel region 101, the second sub-pixel region 102, and the third sub-pixel region 103) are spaced apart from the light shielding region 104.

The first substrate 110 may include a rigid substrate, a flexible substrate, or a combination thereof. For instance, a material of the first substrate 110 may include glass, quartz, sapphire, ceramics, polycarbonate (PC), polyimide (PI), polyethylene terephthalate (PET), other suitable substrate materials, or a combination thereof, which should however not be construed as a limitation in the disclosure.

The circuit layer 120 is disposed on the first substrate 110, and the circuit layer 120 is disposed between the light emitting units 130 and the first substrate 110. The circuit layer 120 may include driving circuits (not shown), such as transistors, scan lines, data lines, and so on, which should however not be construed as a limitation in the disclosure. The circuit layer 120 may be electrically connected to the light emitting units 130, and the circuit layer 120 may drive the light emitting units 130 to emit light.

The light emitting units 130 are disposed on the first substrate 110, and the light emitting units 130 are disposed on the circuit layer 120 or disposed between the intermediate layer 140 and the circuit layer 120. The light emitting units 130 may include a non-self-luminous material or a self-luminous material, where the non-self-luminous material may include LCs or other suitable display media, and the self-luminous material may include organic light emitting diodes or inorganic light emitting diodes, which should however not be construed as a limitation in the disclosure. For instance, the light emitting diodes (LED) may include organic light emitting diodes (OLED), mini LEDs, micro LEDs, or quantum dot light emitting diodes (QLED, QDLED), which should however not be construed as a limitation in the disclosure. For instance, the light emitting units 130 may be a red LED, a green LED, a blue LED, a white LED, or an ultraviolet LED, which should however not be construed as a limitation in the disclosure.

The intermediate layer 140 is disposed on the first substrate 110, where the intermediate layer 140 may achieve insulation, adhesion, protection, leveling, or other suitable effects, which should however not be construed as a limitation in the disclosure. The intermediate layer 140 is disposed between the color filter layer 150 and the light emitting units 130. The intermediate layer 140 may be configured to bond and assemble the first substrate 110 to the second substrate 160. A material of the intermediate layer 140 may include, for instance, an optically clear adhesive (OCA), optical clear resin (OCR), polyfluoroalkoxy (PFA), other suitable materials, or a combination of the above, which should however not be construed as a limitation in the disclosure.

The color filter layer 150 is disposed on the intermediate layer 140, and the color filter layer 150 is disposed between the second substrate 160 and the light emitting units 130. The color filter layer 150 includes a black matrix (BM), a first color resist 151, a second color resist 152, and a third color resist 153.

In detail, the first color resist 151 includes a first portion 1511 and a second portion 1512. The first portion 1511 is disposed on the black matrix BM, the first portion 1511 is disposed between the second substrate 160 and the black matrix BM, and the first portion 1511 may be overlapped with the black matrix BM in a normal direction Z of the first substrate 110. The second portion 1512 is not disposed on the black matrix BM but is disposed between two adjacent black matrices BM, the second portion 1512 is disposed between two adjacent first portions 1511, and the second portion 1512 is not overlapped with the black matrix BM in the normal direction Z of the first substrate 110. In the present embodiment, being "adjacent" means that there are no other identical elements between two same elements. In some embodiments, the first portion 1511 and the second portion 1512 are respectively disposed on two adjacent sides of the black matrix BM (e.g., an upper surface and a side surface adjacent thereto, where the upper surface faces the second substrate 160). In some embodiments, the first portion 1511 and the second portion 1512 may contact the second substrate 160, which should however not be construed as a limitation in the disclosure.

The second color resist 152 and the third color resist 153 are not disposed on the black matrix BM, the second color resist 152 or the third color resist 153 is disposed between two adjacent black matrices BM, the second color resist 152 or the third color resist 153 is disposed between two adjacent first portions 1511, and the second color resist 152 and the third color resist 153 are not overlapped with the black matrix BM in the normal direction Z of the first substrate 110. In some embodiments, the second color resist 152 and the third color resist 153 may contact the second substrate 160, which should however not be construed as a limitation in the disclosure.

The black matrix BM is disposed below the first portion 1511 of the first color resist 151, and the black matrix BM is disposed between the first portion 1511 and the intermediate layer 140. One portion of the black matrix BM is disposed between the second portion 1512 of the first color resist 151 and the second color resist 152. The black matrix BM and the color resists (i.e., the first portion 1511 of the first color resist 151, the second color resist 152, and the third color resist 153) may be spaced apart from one another. In some embodiments, the black matrix BM does not contact the second substrate 160, which should however not be construed as a limitation in the disclosure. In some embodiments, a material of the black matrix BM may include black resin or other suitable light-shielding materials, which should however not be construed as a limitation in the disclosure.

In the present embodiment, the second portion 1512 of the first color resist 151 is disposed corresponding to the first sub-pixel region 101, the second color resist 152 is disposed corresponding to the second sub-pixel region 102, the third color resist 153 is disposed corresponding to the third sub-pixel region 103, and the first portion 1511 of the first color resist 151 and the black matrix BM are disposed corresponding to the light shielding region 104.

The first portion 1511 of the first color resist 151 has a thickness T1, the second portion 1512 of the first color resist 151 has a thickness T2, the second color resist 152 has a thickness T3, and the third color resist 153 has a thickness T4. Here, the thickness T1 is, for instance, the maximum thickness of the first portion 1511 measured along the normal direction Z, the thickness T2 is, for instance, the maximum thickness of the second portion 1512 measured along the normal direction Z, the thickness T3 is, for instance, the maximum thickness of the second color resist 152 measured along the normal direction Z, and the thickness T4 is, for instance, the maximum thickness of the third color resist 153 measured along the normal direction Z. In the present embodiment, the thickness T2 of the second portion 1512 of the first color resist 151 in the first sub-pixel region 101 may be, for instance, greater than the thickness T1 of the first portion 1511 of the first color resist 151 in the light shielding region 104, and the thickness T3 of the second color resist 152 and the thickness T4 of the third color resist 153 may be, for instance, greater than the thickness T1 of the first portion 1511, which should however not be construed as a limitation in the disclosure.

In the present embodiment, the first color resist 151, the second color resist 152, and the third color resist 153 may be color resists or filter materials of different colors, such as red color resists, green color resists, blue color resists, color resists of other colors, filter materials of other colors, or the like. For instance, the first color resist 151 may be a blue color resist, the second color resist 152 may be a green color resist, and the third color resist 153 may be a red color resist, which should however not be construed as a limitation in the disclosure. In some embodiments, the first color resist 151 may also be a color resist of a color other than blue, the second color resist 152 may also be a color resist of a color other than green, and the third color resist 153 may also be a color resist of a color other than red. When the first portion 1511 of the first color resist 151 is the blue color resist, the blue color resist may accomplish a favorable light-absorbing effect compared to color resists of other colors, thereby further reducing reflectivity of external light.

The second substrate 160 is disposed opposite to the first substrate 110. The second substrate 160 includes a first surface 161 and a second surface 162 that are opposite to each other. The first surface 161 faces the color filter layer 150 and the first substrate 110, and the first surface 161 is, compared to the second surface 162, located closer to the color filter layer 150 and the first substrate 110. The second substrate 160 may include a rigid substrate, a flexible substrate, or a combination of the above. For instance, a material of the second substrate 160 may include glass, quartz, sapphire, ceramics, PC, PI, PET, other suitable substrate materials, or a combination of the above, which should however not be construed as a limitation in the disclosure.

In the present embodiment, the first portion 1511 of the first color resist 151 disposed on the black matrix BM may serve as an anti-reflection material layer, which is configured to reduce the reflectivity within the first surface 161 of the second substrate 160 (including the reflectivity of the external light on a surface of the first portion 1511 and the reflectivity of the external light on a surface of the black matrix BM), thereby improving the panel transmittance, reducing power consumption, or enhancing visual perception. For instance, when the reflectivity of the external light within the first surface of the second substrate where no first portion is disposed is 2%, the reflectivity of the external light within the first surface 161 of the second substrate 160 where the first portion 1511 is disposed may be reduced to about 1%.

In the present embodiment, since the first portion 1511 of the first color resist 151, which serves as the anti-reflection material layer, may be formed at the same time of manufacturing the color resists of the color filter layer 150, the manufacturing process may be simplified.

The schematic view in FIG. 1 may be a schematic view after the first substrate 110 and the second substrate 160 are assembled. In the present embodiment, the stack of the first substrate 110 and the stack of the second substrate 160 may be formed separately, and then the stack of the second substrate 160 may be flipped over to face the stack of the first substrate 110 and may be assembled to the stack of the first substrate 110, as shown in FIG. 1, where the second substrate 160 is at the top layer and the first substrate 110 is at the bottom layer. The stack of the first substrate 110 may include the circuit layer 120 and the light emitting units 130 sequentially formed on the first substrate 110, while the stack of the second substrate 160 may include the first portion 1511, the black matrix BM, and the related color resist layers (1512/152/153) sequentially formed on the first surface 161 of the second substrate 160, and then the stack of the second substrate 160 is flipped over to face the stack of the first substrate 110 and adhered and assembled to the stack of the first substrate 110 through the intermediate layer 140.

Other embodiments will be enumerated below for explanation. Note that reference numbers and some content provided in the following embodiments are derived from those in the previous embodiments, the same reference numbers serve to denote the same or similar elements, and the description of the same technical content is omitted. The description of the omitted parts may be referred to as the description in the previous embodiments and will not be redundantly repeated hereinafter.

FIG. 2 is a schematic cross-sectional view of a display panel according to a second embodiment of the disclosure. With reference to FIG. 2 and FIG. 1, a display panel 100a provided in the present embodiment is similar to the display panel 100 provided in FIG. 1, while the difference therebetween lies in that the display panel 100a in the present embodiment further includes an anti-reflection layer AR and an anti-smudge layer AS.

Specifically, with reference to FIG. 2, in the present embodiment, the anti-reflection layer AR is disposed on the second surface 162 of the second substrate 160, and the anti-reflection layer AR and the color filter layer 150 are respectively disposed on two opposite sides of the second substrate 160. The anti-reflection layer AR includes a plurality of high refractive index layers (not shown) and low refractive index layers (not shown) that are alternately arranged in the normal direction Z. For instance, the anti-reflection layer AR may be a composite film composed of two or more alternately arranged high refractive index layers and low refractive index layers (e.g., four layers, sixth layers, etc.). For instance, when the anti-reflection layer AR is a composite film composed of four alternately arranged high refractive index layers and low refractive index layers, the stacked layers of the composite film may sequentially include a first high refractive index layer, a first low refractive index layer, a second high refractive index layer, and a second low refractive index layer from bottom to top. In the present embodiment, a material of the high refractive index layer may include niobium oxide, and a material of the low refractive index layer may include silicon oxide, which should however not be construed as a limitation in the disclosure. In the present embodiment, a refractive index of the high refractive index layers may be 2.5, for instance, and a refractive index of the low refractive index layers may be, 1.5, for instance, which should however not be construed as a limitation in the disclosure.

In the present embodiment, the anti-reflection layer AR may serve to reduce the reflectivity of the external light on the second surface 162 of the second substrate 160 due to light interference effects, thereby further improving the panel transmittance, reducing the power consumption, or enhancing the visual perception. For instance, when the reflectivity of the external light on the second surface of the second substrate where no anti-reflection layer is disposed is 4%, the reflectivity of the external light on the second surface 162 of the second substrate 160 where the anti-reflection layer AR is disposed may be reduced to about 0.2%.

The anti-smudge layer AS is disposed on the anti-reflection layer AR. The anti-smudge layer AS has a thickness T5. The thickness T5 is, for instance, the maximum thickness of the anti-smudge layer AS measured along the normal direction Z. In the present embodiment, the thickness T5 of the anti-smudge layer AS may be, for instance, less than or equal to 20 nanometers (nm), which should however not be construed as a limitation in the disclosure. Besides, in the present embodiment, a material of the anti-smudge layer AS may include fluorine compounds, epoxy resins, acrylics, and so on, which should however not be construed as a limitation in the disclosure.

In the present embodiment, the anti-smudge layer AS may fill capillary pores on the second surface 162 of the second substrate 160 to allow the second surface 162 to become more densely and smoothly, thus making it difficult for dirt and smudges to be adhered to the second substrate 160. The anti-smudge layer AS may be a durable dual-phobic coating film with both hydrophobic and oleophobic properties. Additionally, the anti-smudge layer AS has good light transmittance and thus does not pose any impact on the optical visual effects.

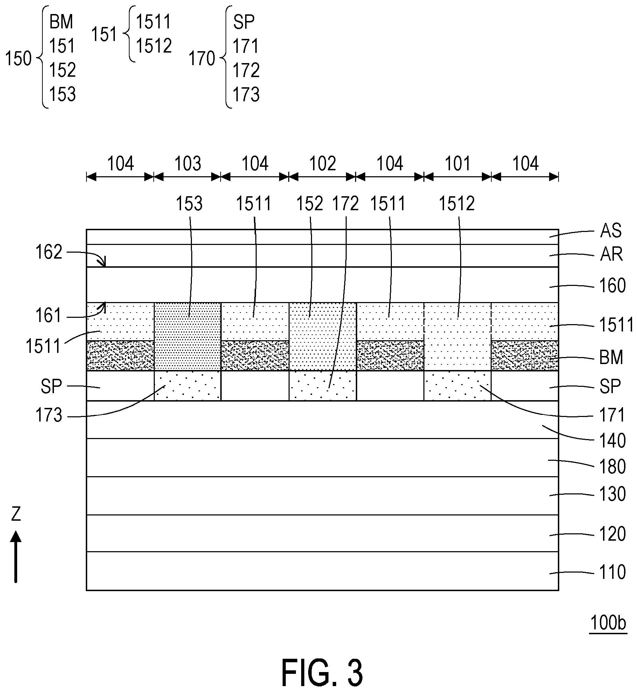

FIG. 3 is a schematic cross-sectional view of a display panel according to a third embodiment of the disclosure. With reference to FIG. 3 and FIG. 2, a display panel 100b provided in the present embodiment is similar to the display panel 100a provided in FIG. 2, while the difference therebetween lies in that the display panel 100b in the present embodiment further includes a light conversion layer 170 and an adhesive layer 180.

Specifically, with reference to FIG. 3, in the present embodiment, the light conversion layer 170 is disposed below the color filter layer 150, and the light conversion layer 170 is disposed between the color filter layer 150 and the intermediate layer 140. The light conversion layer 170 includes spacers SP, a first light conversion unit 171, a second light conversion unit 172, and a third light conversion unit 173. A material of the light conversion units (i.e., the first light conversion unit 171, the second light conversion unit 172, and the third light conversion unit 173) may include QD, fluorescence, phosphor, other suitable materials, or a combination of the above, which should however not be construed as a limitation in the disclosure.

In detail, the light conversion units (i.e., the first light conversion unit 171, the second light conversion unit 172, and the third light conversion unit 173) are spaced apart from the spacers SP, and the light conversion unit (i.e., the first light conversion unit 171, the second light conversion unit 172, or the third light conversion unit 173) is disposed between two adjacent spacers SP. One portion of the spacers SP is disposed between the first light conversion unit 171 and the second light conversion unit 172.

In the normal direction Z of the first substrate 110, the light conversion units (i.e., the first light conversion unit 171, the second light conversion unit 172, and the third light conversion unit 173) are not overlapped with the spacers SP and the black matrix BM. In the normal direction Z of the first substrate 110, the first light conversion unit 171 and the second portion 1512 of the first color resist 151 are overlapped, the second light conversion unit 172 and the second color resist 152 are overlapped, the third light conversion unit 173 and the third color resist 153 are overlapped, and the spacers SP and the black matrix BM are overlapped. In some embodiments, the first light conversion unit 171 may contact the second portion 1512 of the first color resist 151, the second light conversion unit 172 may contact the second color resist 152, the third light conversion unit 173 may contact the third color resist 153, and the spacers SP may contact the black matrix BM, which should however not be construed as a limitation in the disclosure.

The adhesive layer 180 may be optionally disposed on the first substrate 110, and the adhesive layer 180 is disposed between the intermediate layer 140 and the light emitting units 130. When the light emitting units 130 are made of a non-self-luminous material (such as LC), the adhesive layer 180 may serve as a spacer for supporting the LC or adhering and assembling the first substrate 110 to the second substrate 160. When the light emitting units 130 are made of a self-luminous material (such as LED), the adhesive layer 180 may serve as an underfill for fixing the LED or protecting the LED from moisture infiltration.

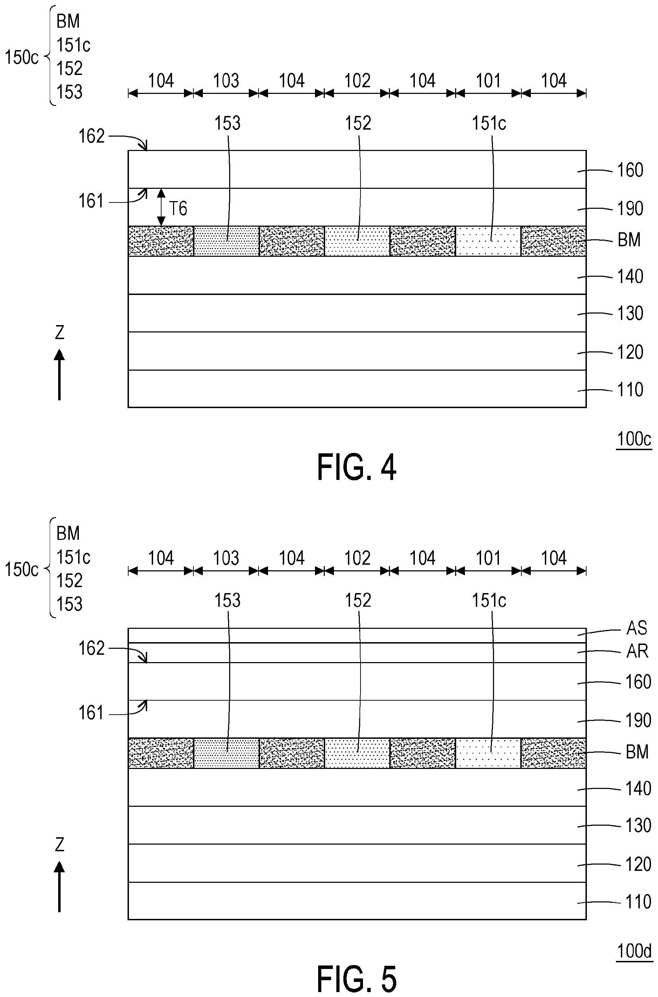

FIG. 4 is a schematic cross-sectional view of a display panel according to a fourth embodiment of the disclosure. With reference to FIG. 4 and FIG. 1, a display panel 100c provided in the present embodiment is similar to the display panel 100 provided in FIG. 1, while the difference therebetween lies in that the display panel 100c in the present embodiment further includes an index matching film (IMF) 190. The IMF 190 may serve as an anti-reflection material layer and may be applied to replace the first portion 1511 of the first color resist 151 in the display panel 100 depicted in FIG. 1.

Specifically, with reference to FIG. 4, in this embodiment, the IMF 190 is disposed on the intermediate layer 140, and the IMF 190 is disposed between the first surface 161 of the second substrate 160 and the color filter layer 150c. In this embodiment, a material of the IMF 190 may include but is not limited to a silicon oxynitride (SiONx) film layer. The SiONx film layer may adjust a refractive index of the IMF 190 by changing the amount of nitrous oxide (N₂O) and ammonia (NH₃).

In this embodiment, the refractive index of the IMF 190 may, for instance, range from the refractive index of the second substrate 160 and the refractive index of the black matrix BM, so as to reduce the reflected light by decreasing the refractive index difference between different materials, which should not be construed as a limitation in the disclosure. For instance, when the second substrate 160 is made of glass, since the refractive index of the glass is 1.5 and the refractive index of the black matrix BM is 1.7 to 1.8, the refractive index of the IMF 190 may, for instance, range from 1.5 to 1.8.

The IMF 190 has a thickness T6. The thickness T6 is, for instance, the maximum thickness of the IMF 190 measured in the normal direction Z. In this embodiment, the thickness T6 of the IMF 190 may be an odd multiple of one-fourth of the incident wavelength, so as to reduce the reflectivity by generating destructive interference. For instance, when the incident wavelength is 550 nm, the thickness T6 of the IMF 190 may, for instance, range from 100 nm to 700 nm, or from 300 nm to 500 nm.

In this embodiment, the IMF 190 disposed on the black matrix BM may act as an anti-reflection material layer and configured to reduce the reflectivity of the external light within the first surface 161 of the second substrate 160 (including the reflectivity of the external light on a surface of the IMF 190 and the reflectivity of the external light on the surface of the black matrix BM), thereby improving the panel transmittance, reducing the power consumption, or enhancing the visual perception. For instance, when the reflectivity of the external light within the first surface of the second substrate where no IMF is disposed is 2%, the reflectivity of the external light within the first surface 161 of the second substrate 160 where the IMF 190 is disposed may be reduced to about 1%.

The color filter layer 150c is disposed between the IMF 190 and the intermediate layer 140. Here, the color resists (i.e., the first color resist 151c, the second color resist 152, and the third color resist 153) are spaced from the black matrix BM. The color resist (i.e., the first color resist 151c, the second color resist 152, or the third color resist 153) is disposed between two adjacent black matrices BM, but the color resist (i.e., the first color resist 151c, the second color resist 152, or the third color resist 153) is not disposed between the second substrate 160 and the black matrix BM. In the normal direction Z of the first substrate 110, the color resists (i.e., the first color resist 151c, the second color resist 152, and the third color resist 153) are not overlapped with the black matrix BM, and the color resists (i.e., the first color resist 151c, the second color resist 152, and the third color resist 153) and the black matrix BM may be overlapped with the IMF 190. One portion of the black matrix BM is disposed between the first color resist 151c and the second color resist 152. In addition, in some embodiments, the color resists (i.e., the first color resist 151c, the second color resist 152, and the third color resist 153) and the black matrix BM may contact the IMF 190 but do not contact the second substrate 160, which should however not be construed as a limitation in the disclosure.

FIG. 5 is a schematic cross-sectional view of a display panel according to a fifth embodiment of the disclosure. With reference to FIG. 5 and FIG. 4, a display panel 100d provided in the present embodiment is similar to the display panel 100c provided in FIG. 4, while the difference therebetween lies in that the display panel 100d in the present embodiment further includes the anti-reflection layer AR and the anti-smudge layer AS.

Specifically, with reference to FIG. 5, in the present embodiment, the anti-reflection layer AR is disposed on the second surface 162 of the second substrate 160, and the anti-reflection layer AR and the color filter layer 150c are respectively disposed on two opposite sides of the second substrate 160. The anti-reflection layer AR includes a plurality of high refractive index layers (not shown) and low refractive index layers (not shown) that are alternately arranged in the normal direction Z. For instance, the anti-reflection layer AR may be a composite film composed of two or more alternately arranged high refractive index layers and low refractive index layers (e.g., four layers, sixth layers, etc.). For instance, when the anti-reflection layer AR is a composite film composed of four alternately arranged high refractive index layers and low refractive index layers, the stacked layers of the composite film may sequentially include a first high refractive index layer, a first low refractive index layer, a second high refractive index layer, and a second low refractive index layer from bottom to top. In the present embodiment, a material of the high refractive index layer may include niobium oxide, and a material of the low refractive index layer may include silicon oxide, which should however not be construed as a limitation in the disclosure. In the present embodiment, the refractive index of the high refractive index layer may be, for instance, 2.5, and the refractive index of the low refractive index layer may be, for instance, 1.5, which should however not be construed as a limitation in the disclosure.

In the present embodiment, the anti-reflection layer AR may serve to reduce the reflectivity of the external light on the second surface 162 of the second substrate 160 due to light interference effects, thereby further improving the panel transmittance, reducing the power consumption, or enhancing the visual perception. For instance, when the reflectivity of the external light on the second surface of the second substrate where no anti-reflection layer is disposed is 4%, the reflectivity of the external light on the second surface 162 of the second substrate 160 where the anti-reflection layer AR is disposed may be reduced to about 0.2%.

The anti-smudge layer AS is disposed on the anti-reflection layer AR. The anti-smudge layer AS has a thickness T5. The thickness T5 is, for instance, the maximum thickness of the anti-smudge layer AS measured along the normal direction Z. In the present embodiment, the thickness T5 of the anti-smudge layer AS may be, for instance, less than or equal to 20 nm, which should however not be construed as a limitation in the disclosure. Besides, in the present embodiment, a material of the anti-smudge layer AS may include fluorine compounds, epoxy resins, acrylics, and so on, which should however not be construed as a limitation in the disclosure.

In the present embodiment, the anti-smudge layer AS may fill capillary pores on the second surface 162 of the second substrate 160 to allow the second surface 162 to become more densely and smoothly, thus making it difficult for dirt and smudges to be adhered to the second substrate 160. The anti-smudge layer AS may be a durable dual-phobic coating film with both hydrophobic and oleophobic properties. Additionally, the anti-smudge layer AS has good light transmittance and thus does not pose any impact on the optical visual effects.

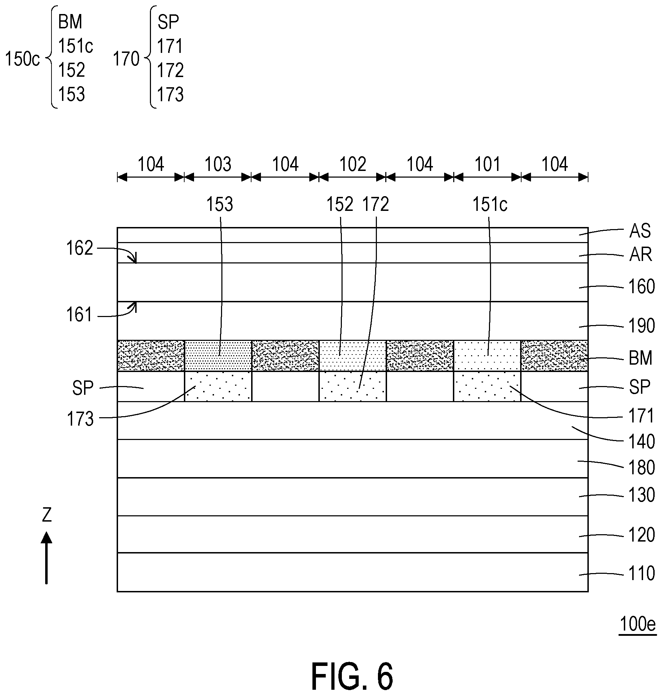

FIG. 6 is a schematic cross-sectional view of a display panel according to a sixth embodiment of the disclosure. With reference to FIG. 6 and FIG. 5, a display panel 100e provided in the present embodiment is similar to the display panel 100d provided in FIG. 5, while the difference therebetween lies in that the display panel 100e in the present embodiment further includes the light conversion layer 170 and the adhesive layer 180.

Specifically, with reference to FIG. 6, in the present embodiment, the light conversion layer 170 is disposed below the color filter layer 150c, and the light conversion layer 170 is disposed between the color filter layer 150c and the intermediate layer 140. The light conversion layer 170 includes spacers SP, a first light conversion unit 171, a second light conversion unit 172, and a third light conversion unit 173. A material of the light conversion units (i.e., the first light conversion unit 171, the second light conversion unit 172, and the third light conversion unit 173) may include QD, fluorescence, phosphor, other suitable materials, or a combination of the above, which should however not be construed as a limitation in the disclosure

In detail, the light conversion units (i.e., the first light conversion unit 171, the second light conversion unit 172, and the third light conversion unit 173) are spaced apart from the spacers SP, and the light conversion unit (i.e., the first light conversion unit 171, the second light conversion unit 172, or the third light conversion unit 173) is disposed between two adjacent spacers SP. One portion of the spacers SP is disposed between the first light conversion unit 171 and the second light conversion unit 172.

In the normal direction Z of the first substrate 110, the light conversion units (i.e., the first light conversion unit 171, the second light conversion unit 172, and the third light conversion unit 173) are not overlapped with the spacers SP and the black matrix BM. In the normal direction Z of the first substrate 110, the first light conversion unit 171 and the first color resist 151c are overlapped, the second light conversion unit 172 and the second color resist 152 are overlapped, the third light conversion unit 173 and the third color resist 153 are overlapped, and the spacers SP and the black matrix BM are overlapped. In some embodiments, the first light conversion unit 171 may contact the first color resist 151c, the second light conversion unit 172 may contact the second color resist 152, the third light conversion unit 173 may contact the third color resist 153, and the spacers SP may contact the black matrix BM, which should however not be construed as a limitation in the disclosure.

The adhesive layer 180 may be optionally disposed on the first substrate 110, and the adhesive layer 180 is disposed between the intermediate layer 140 and the light emitting units 130. When the light emitting units 130 are made of a non-self-luminous material (such as LC), the adhesive layer 180 may serve as a spacer for supporting the LC or adhering and assembling the first substrate 110 to the second substrate 160. When the light emitting units 130 are made of a self-luminous material (such as LED), the adhesive layer 180 may serve as an underfill for fixing the LED or protecting the LED from moisture infiltration.

In some embodiments, e.g., in FIG. 4, FIG. 5, or FIG. 6, the first portion 1511 of the first color resist 151 may be optionally disposed between the IMF 190 and the black matrix BM. As such, there may be a plurality of anti-reflection material layers (the IMF 190 and the first portion 1511 of the first color resist 151) between the second substrate 160 and the black matrix BM, which is conducive to reduction of the reflectivity of the external light within the first surface 161 of the second substrate 160, thereby leading to improvement of the panel transmittance, reduction of the power consumption, or enhancement of the visual perception.

To sum up, in the display panel provided in one or more embodiments of the disclosure, the first portion of the first color resist or the IMF disposed on the black matrix may serve as the anti-reflection material layer and may be configured to reduce the reflectivity of the external light within the first surface of the second substrate (including the reflectivity of the external light on the surface of the first portion or the IMF and the reflectivity of the external light on the surface of the black matrix), thereby improving the panel transmittance, reducing the power consumption, or enhancing the visual perception. In addition, since the anti-reflection film may reduce the reflectivity of the external light on the second surface of the second substrate due to the light interference effects, the panel transmittance may be further improved, the power consumption may be further reduced, or the visual perception may be further enhanced.

## Claims

1. A display panel (100, 100a, 100b), comprising:
a first substrate (110);
a second substrate (160), disposed opposite to the first substrate (110) and comprising a first surface (161) and a second surface (162);
a plurality of light emitting units (130), disposed on the first substrate (110); and
a color filter layer (150), disposed between the second substrate (160) and the light emitting units (130) and comprising a black matrix (BM), a first color resist (151), and a second color resist (152), wherein the black matrix (BM) is disposed below the first color resist (151),
wherein one portion of the black matrix (BM) is disposed between the first color resist (151) and the second color resist (152).

2. The display panel according to claim 1, wherein the first color resist (151) comprises a first portion (1511) disposed on the black matrix (BM) and a second portion (1512) not disposed on the black matrix (BM), and a thickness of the second portion (1512) is greater than a thickness of the first portion (1511).

3. The display panel according to claim 1, further comprising:
an anti-reflection layer (AR), disposed on the second surface (162).

4. The display panel according to claim 3, wherein the anti-reflection layer (AR) comprises a plurality of high refractive index layers and low refractive index layers, and the high refractive index layers and the low refractive index layers are arranged alternately.

5. The display panel according to claim 3, further comprising:
an anti-smudge layer (AS), disposed on the anti-reflection layer (AR).

6. The display panel according to claim 5, wherein the anti-smudge layer (AS) comprises a fluorine compound.

7. The display panel according to claim 1, further comprising:
a light conversion layer (170), disposed below the color filter layer (150) and comprising a spacer (SP), a first light conversion unit (171), and a second light conversion unit (172),
wherein one portion of the spacer (SP) is disposed between the first light conversion unit (171) and the second light conversion unit (172).

8. The display panel according to claim 7, wherein the first light conversion unit (171) and the first color resist (151) are overlapped, the second light conversion unit (172) and the second color resist (152) are overlapped, and the spacer (SP) and the black matrix (BM) are overlapped.

9. A display panel (100c, 100d, 100e), comprising:
a first substrate (110);
a second substrate (160), disposed opposite to the first substrate (110) and comprising a first surface (161) and a second surface (162);
a plurality of light emitting units (130), disposed on the first substrate (110);
a color filter layer (150c), disposed between the light emitting units (130) and the second substrate (160) and comprising a black matrix (BM), a first color resist (151, 151c), and a second color resist (152), wherein one portion of the black matrix (BM) is disposed between the first color resist (151, 151c) and the second color resist (152); and
an index matching film (190), disposed between the second substrate (160) and the color filter layer (150c),
wherein a refractive index of the index matching film (190) ranges from a refractive index of the second substrate (160) to a refractive index of the black matrix (BM).

10. The display panel according to claim 9, further comprising:
an anti-reflection layer (AR), disposed on the second surface (162).

11. The display panel according to claim 10, wherein the anti-reflection layer (AR) comprises a plurality of high refractive index layers and low refractive index layers, and the high refractive index layers and the low refractive index layers are arranged alternately.

12. The display panel according to claim 10, further comprising:
an anti-smudge layer (AS), disposed on the anti-reflection layer (AR).

13. The display panel according to claim 12, wherein the anti-smudge layer (AS) comprises a fluorine compound.

14. The display panel according to claim 9, further comprising:
a light conversion layer (170), disposed below the color filter layer (150c) and comprising a spacer (SP), a first light conversion unit (171), and a second light conversion unit (172),
wherein one portion of the spacer (SP) is disposed between the first light conversion unit (171) and the second light conversion unit (172).

15. The display panel according to claim 14, wherein the first light conversion unit (171) and the first color resist (151c) are overlapped, the second light conversion unit (172) and the second color resist (152) are overlapped, and the spacer (SP) and the black matrix (BM) are overlapped.
